# EUROPEAN PATENT SPECIFICATION

(11) **EP 3 102 720 B1**
(45) Date of publication and mention of the grant of the patent: **21.03.2018**
(21) Application number: 14828551.3
(22) Date of filing: 07.11.2014
(51) Int. Cl.: C30B 19/06, C30B 19/08, C30B 29/52, C30B 19/02

(54) **APPARATUS FOR FORMING EPITAXIAL NANOSTRUCTURES AND RELATED GROWTH PROCESS**
VORRICHTUNG ZUR BILDUNG VON EPITAKTISCHEN NANOSTRUKTUREN UND ZUGEHÖRIGES WACHSTUMSVERFAHREN
APPAREIL POUR FORMER DES NANOSTRUCTURES ÉPITAXIALES ET PROCÉDÉ DE CROISSANCE ASSOCIÉ

(30) Priority: 12.11.2013 IT TO20130912
(43) Date of publication of application: 14.12.2016
(73) Proprietor: Italia Syntesalloys S.p.A., 13900 Biella (IT)
(72) Inventor: MARONCHUK, Igor, I-13900 Biella (IT)
(74) Representative: Garavelli, Paolo
(86) International application number: PCT/IT2014/000295
(87) International publication number: WO 2015/071918

(56) References cited:
- JP-A- S57 211 726
- US-A1- 2007 089 668
- BARYBIN A A ET AL: "AN APPARATUS FOR GROWING MULTILAYER EPITAXIAL GALLIUM ARSENIDE STRUCTURES FROM THE LIQUID STATE", INSTRUMENTS AND EXPERIMENTAL TECHNIQUES,, vol. 17, no. 5, 1 September 1974 (1974-09-01), pages 1514-1515, XP001305043, cited in the application
- A. V. BLAGIN ET AL: "Fabrication of InAs/GaAs quantum dot structures by pulse cooling of high-temperature solution", INORGANIC MATERIALS, vol. 45, no. 12, 1 December 2009 (2009-12-01), pages 1326-1328, XP055126051, ISSN: 0020-1685, DOI: 10.1134/S0020168509120024
- ASTLES M G ET AL: "ISOTHERMAL GaAs LIQUID-PHASE EPITAXY USING A ROTATING SUBSTRATE TECHNIQUE", JOURNAL OF CRYSTAL GROWTH,, vol. 34, no. 1, 1 June 1976 (1976-06-01), pages 24-28, XP001305046, cited in the application

## Description

The present invention refers to an apparatus for forming heterogeneous multi-layer epitaxial nanostructures with ideal matrixes with quantic points and to its related growth process.

Innovative nano-epitaxial structures are known in the art, produced with a known Molecular Beam Epitaxy (MBE) technology and its related apparatus, where the reagents inserted in an ultra-high vacuum chamber with a pressure of about **10⁻⁸** Pa, appear as molecular beams effused by suitable vaporizing cells, the Knudsen cells, and directly affect a rotary substrate where the deposition of new atomic layers occurs. The incidence of the above molecular beams on the heated substrate is regulated in suitable times by means of suitable screening, enabling a very accurate control on the composition of the deposited layer and on the epitaxial nanostructures with very neat interfaces. Moreover, the substrate has a heating temperature variable in the 450-550 °C range, strongly limiting, during the deposition, the inter-diffusion processes between the layers.

This epitaxial technology from molecular beam has disadvantages related to the use and maintenance of a high-vacuum system, with consequent high costs of use of the technology.

Another advanced technology in the field of epitaxial growth is the Metal Organic Vapor Phase Epitaxy (MOVPE), characterized by the use of metallic-organic reagents such as arsenic, phosphor and their hydrides. The deposition process consists in a phase passage from vapor to crystalline solid in a growth chamber under suitable conditions of gaseous flow of reagents, at constant pressure and temperature. The above is a process outside the thermo-dynamical balance, in which the system tends to deposit the excess reagent species in vapor phase to go back towards the balance conditions. The transport and the control of metallic-organic reagents is performed by bubbling therein a gas, usually H2, which is saturated by vapors of its precursor and sent in a controlled amount in the above growth chamber.

In the growth chamber, the high temperature, on the order of 600-700°C, triggers the pyrolysis of the reagents, making thereby available the atomic species to be deposited. Modern MOVPE reactors for industrial use, having a high technological level, allow simultaneously depositing multiple substrates, with evident advantages in terms of production economy. Moreover, there is an optimum versatility as regards the choice of the precursors, and it is not necessary to operate under ultra-high vacuum conditions, with further advantages in terms of maintenance and costs.

A limit of the MOVPE technology is the low quality of the interfaces which can be obtained in the multi-layer structures and in the dangerousness of used metallic-organic precursors and hydrides, which require suitable safety and alarm systems; this technology requires a monitoring of many growth parameters simultaneously, such as information about thickness of deposited layers, their composition and the features of the growing surface.

Growth processes developed both with MBE technology and with MOVPE technology need a high control both of the growth speed, and of the alloy composition and the incorporation of dopant species, allowing to obtain layers with very high purity, constant doping profile which can be modulated, and neat interfaces, in case of growths of multiple layers.

The high control guaranteed by these epitaxial deposition technologies, which allow making materials with thickness having sizes of the order of 1-10 nm, increases the interest in using these epitaxial nanostructures in micro-electronic applications, such as HEMT transistors, laser and new generations of solar cells.

As known, epitaxy is made without internal tensions if, in addition to having the same crystalline structure, the material to be deposited has the same reticular pitch of the substrate.

A small difference is enough between the two reticular pitches to generate in the reticule itself an additional field of elastic forces which can bring about the structure distortion. The reticular misfit between substrate and material to be grown brings about the formation of quantic points, through the Stranski-Krastanov mechanism.

The first step is given by the formation, layer over layer, of a very thin film called "wetting layer" of the material, upon increasing the thickness of the epitaxially grown layer, also the elastic energy stored in the reticule due to the effect of the new internal forces grows, and can exceed the energy linked to the surface tension, triggering the process which brings about the generation of three-dimensional islands, called quantic point.

Both above epitaxial technologies have a limit above all in their use in the production of innovative solar cells, since they produce epitaxial nanostructures characterized by a "wetting layer" with small energy differences between the quantic points, decreasing the quantic efficiency of the solar cell itself.

Another technology known in the field of epitaxial growth is the Liquid Phase Epitaxy (LPE), consisting in the development of epitaxial layers on crystalline substrates from direct precipitation from the liquid phase. The Liquid Phase Epitaxy method, due to the low growth speeds which can be reached, is suitable only for the deposition of thin layers, but allows obtaining high purities because, during the precipitation process, impurities present in the melt generally tend to remain in their liquid phase.

Another method is known of epitaxial growth of nano-dimensional structures from liquid phase through pulse-type cooling (LPE/ICF) of the substrate characterized by the use of the melted solution as solvent, which improves the self-organization process of quantic points, and removes the formation of local tensions between them. The above method is characterized by the presence of an heat exchanger, replacing a thermocouple present in the traditional epitaxial liquid phase technology, which is in contact with the surface of the substrate allows obtaining matrixes with quantic points with high surface density and low dispersion.

Currently, the main disadvantage of the above methods known in the art is the difficult removal of the residuals of melted solution after having formed matrixes with quantic points.

Documents Barybin A. et al: "An apparatus for growing multilayer epitaxial gallium arsenide structures from the liquid state", Instruments and Experimental Techniques, vol. 17. no. 5, 1 September 1974, pages 1514-1515, XP001305043; Astles M.G. et al.: "Isothermal GaAs liquid-phase epitaxy using a rotating substrate technique", Journal of Crystal Growth, vol. 34, no. 1, 1 June 1976, pages 24-28, XP001305046; and JP-A-S57 211726 disclose apparatuses according to the preamble of claim 1.

Object of the present invention is solving the above prior art problems, by providing an apparatus for forming epitaxial nanostructures with ideal matrixes with quantic points.

Another object of the present invention is providing a growth process which allows the complete removal of the melted solution from the surface of the substrate to obtain epitaxial nanostructures with high level of perfection.

The above and other objects and advantages of the present invention, as will result from the following description, are obtained with an apparatus for forming epitaxial nanostructures and related growth process as claimed in claim 1.

Moreover, the above and other objects of the invention are obtained with a growth process as claimed in claim 12.

Preferred embodiments and non-trivial variations of the present invention are the subject matter of the dependent claims.

It is intended that all enclosed claims are an integral part of the present description.

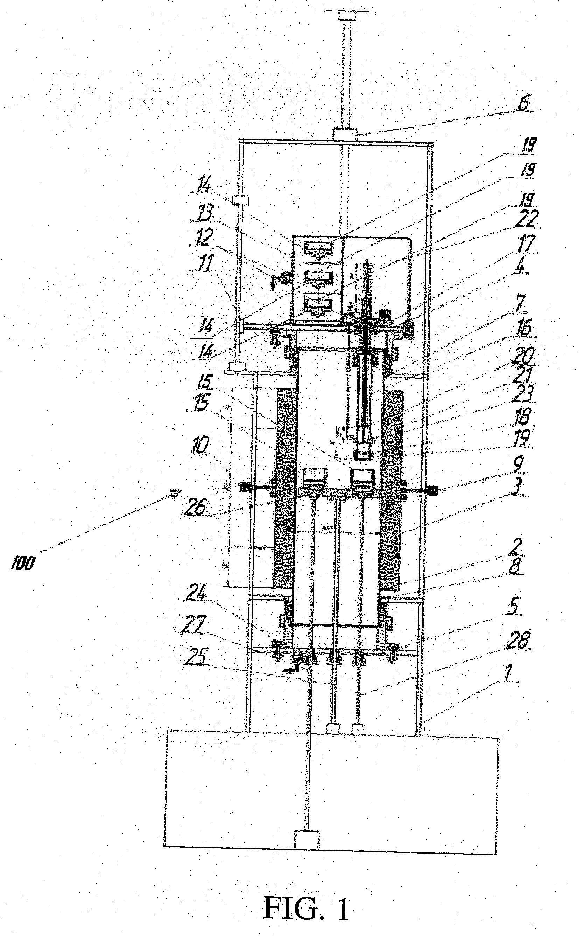

The present invention will be better described by some preferred embodiments thereof, provided as a non-limiting example, with reference to the single enclosed drawing, in which Figure 1 is a side sectional view of a preferred embodiment of the apparatus for forming epitaxial nanostructures according to the present invention.

With reference to the Figures, a preferred embodiment of the present invention is shown and described. It will be immediately obvious that numerous variations and modifications (for example related to shape, sizes, arrangements and parts with equivalent functionalities) could be made to what is described, without departing from the scope of the invention as appears from the enclosed claims.

With reference therefore to the Figure, it can be noted that the apparatus 100 for forming epitaxial nanostructures with ideal matrixes with quantic points according to the present invention is obtained from at least one low-melting alloy, such as an alloy of metals with low melting point or other suitable alloy, and from at least one substrate 19, such as silicon with different crystalline structures, or other type of semiconductor whose thickness and doping are suitable for its use.

The above apparatus 100 comprises at least one external casing 1 made of metallic material or other suitable one, at least one reactor 2 with airtight chamber preferably arranged in a vertical position, and at least one thermal system 3, such as a resistance oven composed of bars, laminas, half-cylinders, or other suitable thermal system winding such reactor 2.

In particular, such external casing 1 comprises:
- at least one vacuum chamber 13 suitable to contain at least one transporting means 14, containing a substrate 19, and at least one containing means 15, during the development of the steps of loading and unloading of the above means;
- at least two handling devices 9 and 10 functional to respectively move the left half and the right half of the thermal system 3;
- at least one handling device 6 necessary for moving the reactor 2, such handling device 6 being preferably fastened onto the internal upper surface of the external casing 1 through at least two fastening elements 7 and 8;
- at least one fastening device 11, suitable to connect an upper cover 4 of the reactor 2 on a lateral internal surface of the external casing 1 and simultaneously to allow the horizontal displacement of the upper cover 4 itself, facilitating the communication between the above chamber 13 and the reactor 2.

In particular, such reactor 2 comprises:
- at least one upper cover 4 fastened onto the lateral internal surface of the external casing 1, equipped with at least one loading entry 12 of a gaseous medium such as pure hydrogen or other suitable means;
- at least one lower cover 5 fastened onto the internal lower surface of the external casing 1, equipped with at least one unloading entry 24 of a gaseous medium such as pure hydrogen or other suitable means;
- at least one cylindrical device 16, fastened onto the above upper cover 4 of the reactor 2, such cylindrical device 16 comprising:
   - at least one device 17 fastened onto the upper cover 4 of the reactor 2 necessary for the rotation of the cylindrical device 16 itself along its own axis, allowing the removal of the residuals of melted solution from the surface of the substrate 19, enabling to obtain ideal matrixes with quantic points;
   - at least one supporting means 18 adapted to accommodate at least one substrate 19 previously transported by at least one transporting means 14;
   - at least one thermal system containing at least one cold plate 20 and at least one pulse-type heater 23 with an annular shape or other suitable shape;
   - at least one mobile heat exchanger 21;
   - at least one handling device 22 necessary for moving the above heat exchanger 21, along the axis of said cylindrical device 16, from the surface of the above cold plate 20 to the upper surface of the substrate 19 and vice versa, and from the upper surface of the substrate 19 to the lateral internal surface of the pulse-type annular heater 23 and vice versa, respectively conveying the cooling and the pulse heating on the above substrate 19;
- at least one handling system, which allows the development of synchronous displacements of the above means 14 and 15 inside the above casing 1, such handling system comprising:
   - at least one rotary positioning device 26, such as a loading disk or other suitable device characterized by a disc-shaped surface equipped with at least two housings suitable to accommodate at least one transporting means 14 and at least one containing means 15, the above device being composed of at least one rotation mechanism 25 and of at least one transmission through-member for the center of the above device 26, fastened onto the internal lower surface of the external casing 1;
   - at least one first handling device 27 with piston, cylinder or other suitable handling mechanism, equipped with a transmission member fastened onto the internal lower surface of the external casing 1, adapted to transfer, in parallel to the axis of the reactor 2, at least one transporting means 14 and at least one containing means 15 from the chamber 13 to the positioning device 26 and vice versa;
   - at least one second handling device 28 with piston, cylinder or other suitable handling mechanism, equipped with a transmission member fastened onto the internal lower surface of the external casing 1, which allows the vertical displacement along the axis of the cylindrical device 16 of at least one transporting means 14, enabling a fastening between the support 18 and at least one substrate 19 moved by the above means 14. Moreover, the above second handling device 28 allows the vertical displacement along the axis of the cylindrical device 16 of at least one containing means 15 next to the lower working surface of the above substrate 19 previously released on the support 18 by the above means 14, enabling to form a growth chamber, between the substrate 19 and the low-melting alloy contained in the containing means 15.

The process for forming a heterogeneous multi-layer epitaxial nanostructure with ideal matrixes with quantic points, according to the present invention, preferably implemented through an apparatus 100 like the previously described one, comprises the following steps:
a) providing the reactor 2, consisting in making vacuum inside the above reactor at a pressure of about **10⁻³ *mmHg*** or other suitable pressure value, and in producing the flow of a gaseous medium such as pure hydrogen, or other suitable means, which induces the heating of the thermal system 3 and consequently of the reactor 2 wound by the above thermal system 3 till the preset temperature is reached;
b) providing in the chamber 13, during the first loading step, at least one transporting means 14, containing at least one substrate 19, and at least one containing means 15 containing at least one low-melting alloy;
c) transferring and sequentially positioning a transporting means 14 and a containing means 15 on the rotating positioning device 26, through the first handling device 27;
d) initially positioning the transporting means 14 containing the substrate 19, through the rotation of the positioning device 26, perpendicularly to the rotation axis of the cylindrical device 16;
e) initially positioning the containing means 15, containing a low-melting alloy, in the housing of the rotary positioning device 26, sequential to the housing which houses the transporting means 14;
f) releasing the substrate 19, moved by the transporting means 14, through the action of the second handling device 28 allowing the vertical displacement along the axis of the cylindrical device 16 of the above means 14 and the fastening of the same and of the related substrate 19 onto the support 18;
g) vertically displacing along the axis of the cylindrical device 16, through the second handling device 28, of the transporting means 14 onto the housing of the rotary positioning device 26;
h) rotating the positioning device 26, through a rotation mechanism 25, which allows the positioning of the above transporting means 14 next to the first handling device 27;
i) vertically displacing in parallel to the axis of the cylindrical device 16, through the first handling device 27, the transporting means 14 in the chamber 13 for the unloading step of the above means 14;
j) rotating the rotary device 26, through a rotation mechanism 25, which allows the positioning of the containing means 15 containing the low-melting alloy next to the substrate 19 fastened at the support 18 to the cylindrical device 16;
k) vertically displacing, along the axis of the cylindrical device 16, the containing means 15, through the action of the second handling device 28, allowing the contact between the low-melting alloy contained in the above means 15 and the substrate 19 and consequently the formation between the above ones of a growth chamber for the crystallization of matrixes with quantic points with n-type conductivity;
1) forming an epitaxial nano-layer conveying onto the substrate 19 a cooling pulse, obtained from the displacement, along the axis of the cylindrical device 16 through the handling device 22, of the heat exchanger 21 initially in contact with the surface of a cold plate 20 characterized by a lower temperature than the temperature of the substrate 19, and afterwards in contact with the upper surface of the above substrate 19;
m) partially dissolving the previously formed epitaxial nano-layer, conveying onto the substrate 19 a heating pulse obtained from the displacement, along the axis of the cylindrical device 16 through the handling device 22, of the heat exchanger 21 from the upper surface of the substrate 19 to the lateral internal surface of the annular heater characterized by an upper temperature than the temperature of the substrate 19, and vice versa;
n) vertically displacing along the axis of the cylindrical device 16, through the second handling device 28, the containing means 15 onto the housing of the rotary positioning device 26, with consequent moving away of the low-melting alloy contained in the above means 15 from the surface of the substrate 19;
o) removing the residuals of the low-melting alloy present on the surface of the substrate 19 through activation of the device 17 adapted to the rotation of the cylindrical device 16 around its own axis, enabling to obtain ideal matrixes with quantic points. The above residuals are collected in the containing means 15 placed in the suitable housing on the rotary device 26;
p) rotating the positioning device 26, through a rotation mechanism 25, which simultaneously allows positioning the above containing means 15 next to the first handling device 27 and of second containing means 15 containing a second low-melting alloy next to the above substrate 19, fastened at the support 18 to the cylindrical device 16;
q) repeating the steps j) to p) of the growth process for a second containing means 15 containing a second low-melting alloy, allowing to form a nanostructure with matrixes with quantic points with n-type conductivity;
r) rotating the positioning device 26, through a rotation mechanism 25, which simultaneously allows positioning the second containing means 15 next to the first handling device 27 and a third containing means 15, containing a third low-melting alloy, next to the above substrate 19, fastened at the support 18 to the cylindrical device 16;
s) repeating the steps k) to o) of the growth process for the third containing means 15 containing a third low-melting alloy, allowing to form a nanostructure with matrixes with quantic points with conductivity of the p type;
t) rotating the positioning device 26, through a rotation mechanism 25, which simultaneously allows positioning the third containing means 15 next to the first handling device 27 and last containing means 15, containing a last low-melting alloy, next to the above substrate 19, fastened at the support 18 to the cylindrical device 16;
u) vertically displacing along the axis of the cylindrical device 16, through first handling device 27, of the above third containing means 15 in the chamber 13 for the unloading step of the above means 15;
v) repeating the steps k) to o) of the above growth process for the last containing means containing a low-melting alloy, allowing to form a nanostructure with matrixes of quantic points with conductivity of the p type;
w) sequentially repeating the steps c) to v) of the above growth process allowing to obtain an heterogeneous multi-layer epitaxial nanostructure with ideal matrixes with quantic points in a single substrate;
x) vertically displacing, along the axis of the cylindrical device 16 through the second handling device 28, the substrate 19 equipped with the grown multi-layer nanostructure, on the housing of the rotary positioning device 26;
y) rotating the positioning device 26, through a rotation mechanism 25, which allows positioning the above substrate 19 next to the first handling device 27;
z) vertically displacing along the axis of the cylindrical device 16, through the first handling device 27, the above substrate 19 in the chamber 13 for the unloading step for the final extraction of the produced heterogeneous multi-layer epitaxial nanostructure; and
aa) possibly vertically displacing along the axis of the cylindrical device 16, through the first handling device 27, such containing means 15 in the chamber 13 for the step of recharging the same, after having spent the low-melting alloy contained, during the growth process, in such means 15.

The invention provides for the following advantages:
- completely removing the melted solution from the surface of the substrate, enabling to form epitaxial nanostructures with ideal matrixes with quantic points;
- allowing the partial dissolution of the grown quantic points which have structural defects through the use of a heating element such as the pulse-type annular heater which allows forming a layer with nanometer thickness as coverage of the matrix with quantic points;

- forming heterogeneous multi-layer epitaxial nanostructures characterized by the presence of three or more materials;
   - guaranteeing the formation of epitaxial nanostructures with a high level of perfection, characterized by neat interfaces, above all in case of growths of multiple layers;
   - ensuring a homogeneous distribution of the features on the whole area of the substrate using a pulse-type cooling and heating system.

## Claims

1. Apparatus (100) for forming epitaxial nanostructures with ideal matrixes with quantic points, obtained starting from at least one low-melting alloy and from at least one substrate (19), said apparatus (100) comprising at least one reactor (2) with airtight chamber, at least one thermal heating system (3) of said reactor (2), said reactor (2) comprising at least one cylindrical device (16) adapted to remove residuals of melted solution from a surface of said substrate (19), and at least one handling system of said substrate (19) and of said low-melting alloy inside said reactor (2), said at least one cylindrical device (16) being placed on at least one upper cover (4) of said reactor (2), and further comprising:
- at least one device (17) fastened on said upper cover (4) of said reactor (2) adapted to rotate said cylindrical device (16) along an axis thereof, for removing the residuals of melted solution from a surface of said substrate (19);
- at least one supporting means (18) adapted to accommodate at least one substrate (19) moved by at least one transporting means (14);
- at least one thermal system containing at least one cold plate (20) and at least one pulse-type annular heater (23), adapted to heat and pulse cool said substrate (19), enabling a process for forming epitaxial nanostructures;
- at least one mobile heat exchanger (21);
- at least one handling device (22);
**characterized in that** said at least one handling device (22) is adapted to displace said heat exchanger (21), along an axis of said cylindrical device (16), (a) from a surface of at least one of said cold plates (20) to an upper surface of at least one of said substrates (19) and vice versa, conveying a pulse cooling onto said substrate (19), or (b) from the upper surface of at least one of said substrates (19) to the lateral internal surface of at least one pulse-type annular heater (23) and vice versa, conveying a pulse heating onto said substrate (19).

2. Apparatus (100) according to claim 1, **characterized in that** it comprises at least one external casing (1), said external casing (1) comprising:
- at least one vacuum chamber (13) adapted to contain at least one containing means (15) and at least one of said transporting means (14), when developing at least one loading step and of at least one unloading step of said means (14) and (15);
- at least two handling devices (9) and (10) adapted to move said thermal system (3);
- at least one handling device (6) adapted to move said reactor (2), placed on the internal upper surface of said external casing (1), through at least two fastening elements (7) and (8);
- at least one fastening device (11), adapted to connect at least one upper cover (4) of said reactor (2) on the lateral internal surface of said external casing (1) and to allow an horizontal displacement of said upper cover (4), to facilitate the communication between at least said chamber (13) and at least said reactor (2).

3. Apparatus (100) according to claim 1, **characterized in that** said low-melting alloy is contained in at least one containing means (15).

4. Apparatus (100) according to claim 1, **characterized in that** said handling system comprises at least one rotary positioning device (26) and at least two handling devices (27) and (28) adapted to enable the development of synchronous displacements of said at least one transporting means (14) containing said substrate (19) and of said at least one containing means (15) containing said low-melting alloy, inside said external casing (1).

5. Apparatus (100) according to claim 1, **characterized in that** said at least one reactor (2) is vertically placed in said external casing (1) and further comprises:
- at least one of said upper covers (4) fastened on a lateral internal surface of said external casing (1), said upper cover (4) being equipped with at least one loading entry (12) of a gaseous medium;
- at least one lower cover (5) fastened onto the internal lower surface of said external casing (1) equipped with at least one unloading entry (24) of a gaseous medium.

6. Apparatus (100) according to claim 4, **characterized in that** said at least rotary positioning device (26) has a disc-shaped surface equipped with at least two housings adapted to accommodate at least one of said transporting means (14) and at least one of said containing means (15).

7. Apparatus (100) according to claim 4 or 6, **characterized in that** said at least one positioning device (26) is adapted to rotate and is composed of at least one rotation mechanism (25) and of at least one transmission through-member for a center of said device (26), fastened onto an internal lower surface of said external casing (1).

8. Apparatus (100) according to claim 4, **characterized in that** said at least one first handling device (27) is equipped with at least one transmission member fastened onto an internal lower surface of said external casing (1), adapted to transfer, in parallel to an axis of said reactor (2), of at least one of said transporting means (14) and at least one of said containing means (15) from said chamber (13) to said positioning device (26) and vice versa.

9. Apparatus (100) according to claim 4, **characterized in that** said at least one second handling device (28) is equipped with at least one transmission member fastened onto the internal lower surface of said external casing (1), adapted to vertically displace, along an axis of said cylindrical device (16), at least one of said transporting means (14), enabling a fastening between at least one of said supporting means (18) and at least one of said substrates (19) moved by at least one of said transporting means (14).

10. Apparatus (100) according to claim 4, **characterized in that** said at least one second handling device (28) is equipped with at least one transmission member fastened onto an internal lower surface of said external casing (1), adapted to vertically displace, along an axis of said cylindrical device (16), at least one of said containing means (15) next to a lower surface of said substrate (19) previously released on said supporting means (18) from said transporting means (14), enabling to form a growth chamber, between said substrate (19) and said low-melting alloy contained in said containing means (15).

11. Growth process for the production of epitaxial nanostructures with ideal matrixes with quantic points through an apparatus (100) according to any one of the previous claims, **characterized in that** it comprises the steps of:
a) providing at least one of said reactors (2) making vacuum inside said reactor (2) and producing a flow of a gaseous medium adapted to heat said thermal system (3) and said reactor (2) till a preset temperature is reached;
b) providing in said chamber (13), during a first loading step, at least one of said transporting means (14), containing at least one of said substrates (19), and at least one of said containing means (15) containing at least one low-melting alloy;
c) transferring and sequentially positioning said transporting means (14) and said containing means (15) onto said rotary positioning device (26), through said first handling device (27);
d) initially positioning said transporting means (14) containing said substrate (19), through a rotation of said positioning device (26);
e) initially positioning said containing means (15) into a housing of said rotary positioning device (26), sequential to a housing which houses said transporting means (14);
f) releasing said substrate (19), moved by said transporting means (14), through an action of said second handling device (28) adapted to vertically displace, along an axis of said cylindrical device (16), said transporting means (14) and to fasten the same and said related substrate (19) onto said supporting means (18);
g) vertically displacing along an axis of said cylindrical device (16), through said second handling device (28), said transporting means (14) onto an housing of said rotary positioning device (26);
h) rotating said positioning device (26), through said rotation mechanism (25) adapted to position said transporting means (14) next to said first handling device (27);
i) vertically displacing in parallel to an axis of said cylindrical device (16), through said first handling device (27), said transporting means (14) in said chamber (13) for an unloading step of said transporting means (14);
j) rotating said positioning device (26), through said rotation mechanism (25), for positioning said containing means (15) next to said substrate (19) fastened to said supporting means (18) to said cylindrical device (16);
k) vertically displacing along an axis of said cylindrical device (16) of said containing means (15), through an action of said second handling device (28), allowing a contact between said low-melting alloy contained in said containing means (15) and said substrate (19) and a formation between said containing means (15) and said substrate (19) of a growth chamber for crystallizing matrixes of quantic points with n-type conductivity;
1) forming an epitaxial nanolayer conveying a cooling pulse onto said substrate (19), said cooling pulse being obtained from a displacement, along an axis of said cylindrical device (16) through said handling device (22), of said heat exchanger (21) initially in contact with said surface of said cold plate (20) having a lower temperature than the temperature of said substrate (19), and afterwards in contact with said upper surface of said substrate (19);
m) partially dissolving said epitaxial nanolayer conveying onto said substrate (19) a heating pulse obtained from a displacement, along an axis of said cylindrical device (16) through said handling device (22), of said heat exchanger (21) from said upper surface of said substrate (19) to said lateral internal surface of the annular heater, having an upper temperature than the temperature of said substrate (19), and vice versa;
n) vertically displacing along an axis of said cylindrical device (16), through said second handling device (28), said containing means (15) onto said housing of said rotary positioning device (26), with consequent moving away of said low-melting alloy contained in said containing means (15) from said surface of said substrate (19);
o) removing residuals of said low-melting alloy present on said surface of said substrate (19) by activating said device (17) adapted to rotate said cylindrical device (16) along an axis thereof, and collecting said residuals of said containing means (15) placed in said housing on said positioning device (26);
p) rotating said positioning device (26), through said rotation mechanism (25), adapted to simultaneously position said containing means (15) next to said first handling device (27) and second containing means (15) containing a second low-melting alloy next to said substrate (19), fastened to said supporting means (18) to said cylindrical device (16);
q) repeating the steps j) to p) for a second containing means (15) containing said second low-melting alloy;
r) rotating said positioning device (26), through a rotation mechanism (25), adapted to simultaneously position said second containing means (15) next to said first handling device (27) and third containing means (15), containing a third low-melting alloy, next to said substrate (19), fastened to said supporting means (18) to said cylindrical device (16);
s) repeating the steps k) to o) for said third containing means (15) containing said third low-melting alloy;
t) rotating said positioning device (26), through said rotation mechanism (25), adapted to simultaneously position said third containing means (15) next to said first handling device (27) and last containing means (15), containing a last low-melting alloy, next to said substrate (19), fastened to said supporting means (18) to said cylindrical device (16);
u) vertically displacing along an axis of said cylindrical device (16), through said first handling device (27), said third containing means (15) in said chamber (13) for an unloading step of said containing means (15);
v) repeating the steps k) to o) for said last containing means (15) containing said low-melting alloy;
w) sequentially repeating the steps c) to v) to obtain an heterogeneous multi-layer epitaxial nanostructure with ideal matrix with quantic points in a single substrate;
x) vertically displacing, along an axis of said cylindrical device (16) through said second handling device (28), said substrate (19) with an increased heterogeneous multi-layer nanostructure, on said housing of said rotary positioning device (26);
y) rotating said positioning device (26), through said rotation mechanism (25), adapted to position said substrate (19) next to said first handling device (27);
z) vertically displacing along an axis of said cylindrical device (16), through said first handling device (27), said substrate (19) in said chamber (13) for an unloading step for finally extracting said produced heterogeneous multi-layer epitaxial nanostructure; and
aa) possibly vertically displacing, along an axis of said cylindrical device (16), through said first handling device (27), said containing means (15) in said chamber (13) for a step of reloading said means (15), after having spent said low-melting alloy contained, during said growth process, in said containing means (15).

## Patentansprüche

1. Gerät (100) für die Bildung von epitaktischen Nanostrukturen mit idealen Matrixen mit Quantenpunkten, die aus mindestens einer niedrigschmelzenden Legierung und aus mindestens einem Substrat (19) erhalten werden, das Gerät (100) enthält mindestens einen Reaktor (2) mit dichter Kammer, mindestens ein Heizsystem (3) des genannten Reaktors (2), der genannte Reaktor (2) enthält mindestens eine zylinderförmige Vorrichtung (16), die dazu dient, Reste der geschmolzenen Lösung von einer Oberfläche des genannten Substrats (19) zu entfernen, und mindestens ein Handhabungssystem des genannten Substrats (19) und der genannten niedrigschmelzenden Legierung im genannten Reaktor (2), die genannte mindestens eine zylinderförmige Vorrichtung (16) ist auf mindestens einer oberen Abdeckung (4) des genannten Reaktors (2) positioniert, und das Gerät enthält außerdem:
- mindestens eine Vorrichtung (17), die an der genannten oberen Abdeckung (4) des genannten Reaktors (2) befestigt ist, der dazu dient, die genannte zylinderförmige Vorrichtung (16) längs ihrer Achse zu drehen, um die Reste der geschmolzenen Lösung von einer Oberfläche des genannten Substrats (19) zu entfernen;
- mindestens ein Trägermedium (18), das dazu dient, mindestens ein Substrat (19) aufzunehmen, das durch ein Transportmedium (14) übertragen wird;
- mindestens ein Heizsystem, das mindestens eine Kühlplatte (20) und mindestens einen Impuls-Heizring (23) enthält, die dazu dienen, das genannte Substrat (19) mit Impulsen zu erhitzen und zu kühlen, um dadurch ein Verfahren zur Bildung von epitaktischen Nanostrukturen zu fördern;
- mindestens einen mobilen Wärmetauscher (21);
- mindestens eine Handhabungsvorrichtung (22);
**und ist dadurch gekennzeichnet, dass** die genannte mindestens eine Handhabungsvorrichtung (22) dazu dient, den genannten Wärmetauscher (21) längs einer Achse der genannten zylinderförmigen Vorrichtung (16) (a) von einer Oberfläche mit mindestens einer der genannten Kühlplatten (20) auf eine obere Fläche mit mindestens einem der genannten Substrate (19) und umgekehrt zu verschieben, und eine Impulskühlung auf das genannte Substrat (19) zu leiten, oder (b) von der oberen Fläche mit mindestens einem der genannten Substrate (19) auf die seitliche interne Oberfläche mit mindestens einem Impuls-Heizring (23) und umgekehrt zu verschieben, und eine Impulserhitzung auf das genannte Substrat (19) zu leiten.

2. Gerät (100) gemäß Patentanspruch 1, das **dadurch gekennzeichnet ist, dass** es mindestens eine externe Umhüllung (1) enthält, die genannte externe Umhüllung (1) enthält:
- mindestens eine Vakuumkammer (13), die dazu dient, während der Entwicklung von mindestens einer Befüllungs- und mindestens einer Entleerungsphase der genannten Medien (14) und (15) mindestens ein Behältermedium (15) und mindestens eines der genannten Transportmedien (14) zu enthalten;
- mindestens zwei Handhabungsvorrichtungen (9) und (10), die dazu dienen, das gesamte Heizsystem (3) zu handhaben;
- mindestens eine Handhabungsvorrichtung (6), die dazu dient, den genannten Reaktor (2), der auf der oberen internen Fläche der genannten externen Umhüllung (1) positioniert ist, durch mindestens zwei Befestigungselemente (7) und (8) zu handhaben;
- mindestens eine Befestigungsvorrichtung (11), die dazu dient, mindestens eine obere Abdeckung (4) des genannten Reaktors (2) auf der seitlichen internen Oberfläche der genannten externen Umhüllung (1) zu verbinden und eine horizontale Verschiebung der genannten oberen Abdeckung (4) zu ermöglichen, um die Kommunikation zwischen mindestens der genannten Kammer (13) und mindestens dem genannten Reaktor (2) zu vereinfachen.

3. Gerät (100) gemäß Patentanspruch 1, das **dadurch gekennzeichnet ist, dass** die genannte niedrigschmelzende Legierung in mindestens einem Behältermedium (15) enthalten ist.

4. Gerät (100) gemäß Patentanspruch 1, das **dadurch gekennzeichnet ist, dass** das genannte Handhabungssystem mindestens eine rotierende Positionierungsvorrichtung (26) und mindestens zwei Handhabungsvorrichtungen (27) und (28) enthält, die dazu dienen, die Entwicklung der Synchronverschiebungen des genannten mindestens einen Transportmediums (14), das das genannte Substrat (19) enthält, und des genannten mindestens einen Behältermediums (15), das die genannte niedrigschmelzende Legierung enthält, in der genannten externen Umhüllung (1) zu fördern.

5. Gerät (100) gemäß Patentanspruch 1, das **dadurch gekennzeichnet ist, dass** der genannte mindestens eine Reaktor (2) vertikal in der genannten externen Umhüllung (1) positioniert ist und außerdem Folgendes enthält:
- mindestens eine der oberen Abdeckungen (4), die auf einer seitlichen internen Oberfläche der genannten externen Umhüllung (1) befestigt ist, die genannte obere Abdeckung (4) ist mit mindestens einer Befüllungsöffnung (12) eines gasförmigen Mediums ausgestattet;
- mindestens eine untere Abdeckung (5), die auf der unteren internen Oberfläche der genannten externen Umhüllung (1) befestigt ist, die mit mindestens einer Entleerungsöffnung (24) eines gasförmigen Mediums ausgestattet ist.

6. Gerät (100) gemäß Patentanspruch 4, das **dadurch gekennzeichnet ist, dass** die genannte mindestens eine rotierende Positionierungsvorrichtung (26) eine scheibenförmige Oberfläche aufweist, die mit mindestens zwei Aufnahmen ausgestattet ist, die dazu dienen, mindestens eines der genannten Transportmedien (14) und mindestens eines der genannten Behältermedien (15) aufzunehmen.

7. Gerät (100) gemäß Patentanspruch 4 oder 6, das **dadurch gekennzeichnet ist, dass** die genannte mindestens eine Positionierungsvorrichtung (26) dazu dient, sich zu drehen, und aus mindestens einem Rotationsmechanismus (25) und aus mindestens einem Übertragungselement besteht, das durch eine Mitte der genannten Vorrichtung (26) geht, die auf einer unteren internen Oberfläche der genannten externen Umhüllung (1) befestigt ist.

8. Gerät (100) gemäß Patentanspruch 4, das **dadurch gekennzeichnet ist, dass** die genannte mindestens eine Handhabungsvorrichtung (27) mit mindestens einem Übertragungselement ausgestattet ist, das auf einer unteren internen Oberfläche der genannten externen Umhüllung (1) befestigt ist, welches dazu dient, parallel zu einer Achse des genannten Reaktors (2) mindestens eines der genannten Transportmedien (14) und mindestens eines der genannten Behältermedien (15) aus der genannten Kammer (13) auf die genannte Positionierungsvorrichtung (26) und umgekehrt zu übertragen.

9. Gerät (100) gemäß Patentanspruch 4, das **dadurch gekennzeichnet ist, dass** die genannte mindestens zweite Handhabungsvorrichtung (28) mit mindestens einem Übertragungselement ausgestattet ist, das auf der unteren internen Oberfläche der genannten externen Umhüllung (1) befestigt ist, welches dazu dient, vertikal längs einer Achse der genannten zylinderförmigen Vorrichtung (16) mindestens eines der genannten Transportmedien (14) zu verschieben und eine Verbindung zwischen mindestens einem der genannten Trägermedien (18) und mindestens einem der genannten Substrate (19) zu fördern, das durch mindestens eines der genannten Transportmedien (14) übertragen wird.

10. Gerät (100) gemäß Patentanspruch 4, das **dadurch gekennzeichnet ist, dass** die genannte mindestens eine zweite Handhabungsvorrichtung (28) mit mindestens einem Übertragungselement ausgestattet ist, das auf einer unteren internen Oberfläche der genannten externen Umhüllung (1) befestigt ist, welches dazu dient, vertikal längs einer Achse der genannten zylinderförmigen Vorrichtung (16) mindestens eines der genannten Behältermedien (15) in der Nähe einer unteren Oberfläche des genannten Substrats (19) zu verschieben, das vorher durch die genannten Transportmedien (14) auf den genannten Trägermedien (18) freigesetzt wurde und die Bildung einer Wachstumskammer zwischen dem genannten Substrat (19) und der genannten niedrigschmelzenden Legierung fördert, die in den genannten Behältermedien (15) enthalten ist.

11. Wachstumsverfahren für die Erzeugung von epitaktischen Nanostrukturen mit idealen Matrizen mit Quantenpunkten durch ein Gerät (100) gemäß einem der vorhergehenden Patentansprüche, das **dadurch gekennzeichnet** ist, folgende Phasen zu enthalten:
a) Vorbereitung von mindestens einem der genannten Reaktoren (2), indem ein Vakuum im genannten Reaktor (2) erzeugt und ein Fluss eines gasförmigen Mediums erzeugt werden, das dazu dient, das genannte Heizsystem (3) und den genannten Reaktor (2) bis zum Erreichen einer vorbestimmten Temperatur zu erhitzen;
b) Vorbereitung in der genannten Kammer (13) während einer ersten Befüllungsphase von mindestens einem der genannten Transportmedien (14), das mindestens eines der genannten Substrate (19) und mindestens eines der genannten Behältermedien (15) enthält, welches mindestens eine niedrigschmelzende Legierung enthält:
c) Übertragung und sequentielle Positionierung der genannten Transportmedien (14) und der genannten Behältermedien (15) auf die genannte rotierende Positionierungsvorrichtung (26) durch die genannte erste Handhabungsvorrichtung (27);
d) Anfängliche Positionierung der genannten Transportmedien (14), die das genannte Substrat (19) enthalten, durch eine Rotation der genannten Positionierungsvorrichtung (26);
e) Anfängliche Positionierung der genannten Behältermedien (15) in einer Aufnahme der genannten rotierenden Positionierungsvorrichtung (26), sequentiell zu einer Aufnahme, die die genannten Transportmedien (14) aufnimmt;
f) Freisetzung des genannten Substrats (19), das durch die genannten Transportmedien (14) durch eine Wirkung der genannten zweiten Handhabungsvorrichtung (28) übertragen wird, die dazu dient, das genannte Transportmedium (14) vertikal längs einer Achse der genannten zylinderförmigen Vorrichtung (16) zu verschieben und dieses und das entsprechende Substrat (19) auf den genannten Trägermedien (18) zu verbinden;
g) Vertikale Verschiebung längs einer Achse der genannten zylinderförmigen Vorrichtung (16) durch die genannte zweite Handhabungsvorrichtung (28) der genannten Transportmedien (14) auf einer Aufnahme der genannten rotierenden Positionierungsvorrichtung (26);
h) Rotation der genannten Positionierungsvorrichtung (26) durch den genannten Rotationsmechanismus (25), der dazu dient, die genannten Transportmedien (14) an der genannten ersten Handhabungsvorrichtung (27) zu positionieren;
i) Vertikale Verschiebung parallel zu einer Achse der genannten zylinderförmigen Vorrichtung (16) durch die genannte erste Handhabungsvorrichtung (27) der genannten Transportmedien (14) in der genannten Kammer (13) für eine Entleerungsphase der genannten Transportmedien (14);
j) Rotation der genannten Positionierungsvorrichtung (26) durch den genannten Rotationsmechanismus (25) für die Positionierung der genannten Behältermedien (15) am genannten Substrat (19), das mit den genannten Trägermedien (18) an der genannten zylinderförmigen Vorrichtung (16) befestigt wird;
k) Vertikale Verschiebung längs einer Achse der genannten zylinderförmigen Vorrichtung (16) der genannten Behältermedien (15) durch eine Wirkung der genannten zweiten Handhabungsvorrichtung (28), indem ein Kontakt zwischen der genannten niedrigschmelzenden Legierung, die in den genannten Behältermedien (15) enthalten ist, und dem genannten Substrat (19) und eine Bildung zwischen den genannten Behältermedien (15) und dem genannten Substrat (19) einer Wachstumskammer für die Kristallisierung der Matrixen mit den Quantenpunkten mit Leitfähigkeit Typ n ermöglicht wird;
1) Bildung einer epitaktischen Nanoschicht durch Leiten eines Kühlimpulses auf das genannte Substrat (19), der genannte Kühlimpuls wird durch eine Verschiebung längs einer Achse der genannten zylinderförmigen Vorrichtung (16) durch die genannte Handhabungsvorrichtung (22) des genannten Wärmetauschers (21) erhalten, der anfangs in Kontakt mit der genannten Oberfläche der genannten Kühlplatte (20) ist und eine niedrigere Temperatur als diejenige des genannten Substrats (19) hat, und danach in Kontakt mit der genannten oberen Fläche des genannten Substrats (19) ist;
m) Teilweise Auflösung der genannten epitaktischen Nanoschicht mit Leitung auf das genannte Substrat (19) eines Heizimpulses, der durch eine Verschiebung längs einer Achse der genannten zylinderförmigen Vorrichtung (16) durch die genannte Handhabungsvorrichtung (22) des genannten Wärmetauschers (21) von der oberen Fläche des genannten Substrats (19) auf die genannte seitliche interne Oberfläche des Heizrings erhalten wird, der eine höhere Temperatur als diejenige des genannten Substrats (19) und umgekehrt hat;
n) Vertikale Verschiebung längs einer Achse der genannten zylinderförmigen Vorrichtung (16) durch die genannte zweite Handhabungsvorrichtung (28) der genannten Behältermedien (15) auf der genannten Aufnahme der genannten rotierenden Positionierungsvorrichtung (26) mit folgender Entfernung der genannten niedrigschmelzenden Legierung, die in den genannten Behältermedien (15) enthalten ist, von der genannten Oberfläche des genannten Substrats (19);
o) Entfernung der Reste der genannten niedrigschmelzenden Legierung, die auf der genannten Oberfläche des genannten Substrats (19) vorhanden sind, durch Aktivierung der genannten Vorrichtung (17), die dazu dient, die genannte zylinderförmige Vorrichtung (16) längs ihrer Achse zu drehen, und Sammlung der genannten Reste der genannten Behältermedien (15), die in der genannten Aufnahme auf der genannten Positionierungsvorrichtung (26) positioniert ist;
p) Rotation der genannten Positionierungsvorrichtung (26) durch den genannten Rotationsmechanismus (25), die dazu dient, die genannten Behältermedien (15) simultan an der genannten ersten Handhabungsvorrichtung (27) und die zweiten Behältermedien (15), die eine zweite niedrigschmelzende Legierung enthalten, am genannten Substrat (19) zu positionieren, das mit den genannten Trägermedien (18) an der genannten zylinderförmigen Vorrichtung (16) befestigt wird;
q) Wiederholung der Phasen von j) bis p) für zweite Behältermedien (15), die die genannte zweite niedrigschmelzende Legierung enthalten;
r) Rotation der genannten Positionierungsvorrichtung (26) durch einen genannten Rotationsmechanismus (25), die dazu dient, die genannten zweiten Behältermedien (15) simultan an der genannten ersten Handhabungsvorrichtung (27) und die dritten Behältermedien (15), die eine dritte niedrigschmelzende Legierung enthalten, am genannten Substrat (19) zu positionieren, das mit den genannten Trägermedien (18) an der genannten zylinderförmigen Vorrichtung (16) befestigt wird;
s) Wiederholung der Phasen von k) bis o) für dritte Behältermedien (15), die die genannte dritte niedrigschmelzende Legierung enthalten;
t) Rotation der genannten Positionierungsvorrichtung (26) durch den genannten Rotationsmechanismus (25), die dazu dient, die genannten dritten Behältermedien (15) simultan an der genannten ersten Handhabungsvorrichtung (27) und die letzten Behältermedien (15), die eine letzte niedrigschmelzende Legierung enthalten, am genannten Substrat (19) zu positionieren, das mit den genannten Trägermedien (18) an der genannten zylinderförmigen Vorrichtung (16) befestigt wird;
u) Vertikale Verschiebung längs einer Achse der genannten zylinderförmigen Vorrichtung (16) durch die genannte erste Handhabungsvorrichtung (27) der genannten dritten Behältermedien (15) in der genannten Kammer (13) für eine Entleerungsphase der genannten Behältermedien (15);
v) Wiederholung der Phasen von k) bis o) für die genannten letzten Behältermedien (15), die die genannte dritte niedrigschmelzende Legierung enthalten;
w) Sequentielle Wiederholungen der Phasen von c) bis v), um eine heterogene mehrschichtige epitaktische Nanostruktur mit idealen Matrixen mit Quantenpunkten in einem einzigen Substrat zu erhalten;
x) Vertikale Verschiebung längs einer Achse der genannten zylinderförmigen Vorrichtung (16) durch die genannte zweite Handhabungsvorrichtung (28) des genannten Substrats (19) mit einer erhöhten heterogenen mehrschichtigen Nanostruktur auf der genannten Aufnahme der genannten rotierenden Positionierungsvorrichtung (26);
y) Rotation der genannten Positionierungsvorrichtung (26) durch den genannten Rotationsmechanismus (25), die dazu dient, das genannte Substrat (19) an der genannten ersten Handhabungsvorrichtung (27) zu positionieren;
z) Vertikale Verschiebung längs einer Achse der genannten zylinderförmigen Vorrichtung (16) durch die genannte erste Handhabungsvorrichtung (27) des genannten Substrats (19) in der genannten Kammer (13) für eine Entleerungsphase für eine abschließende Extraktion der genannten erzeugten heterogenen mehrschichtigen epitaktischen Nanostruktur; und
aa) mögliche vertikale Verschiebung längs einer Achse der genannten zylinderförmigen Vorrichtung (16) durch die genannte erste Handhabungsvorrichtung (27) der genannten Behältermedien (15) in der genannten Kammer (13) für eine erneute Befüllungsphase der genannten Medien (15), nach der Erschöpfung der enthaltenen genannten niedrigschmelzenden Legierung während des genannten Wachstumsverfahrens in den genannten Behältermedien (15).

## Revendications

1. Appareil (100) pour la formation de nanostructures épitaxiales avec des matrices idéales à points quantiques, obtenues à partir d'un alliage à bas point de fusion et d'un substrat (19) au moins ; l'appareil (100) comprend au moins un réacteur (2) à chambre de décompression et un système thermique de chauffage (3) du réacteur (2) ; le réacteur (2) comprend au moins un dispositif cylindrique (16) apte à éliminer d'une surface de ce substrat (19) les résidus de solution fondue, et au moins un système de manutention du substrat (19) et de l'alliage à bas point de fusion à l'intérieur du réacteur (2) ; au moins un dispositif cylindrique (16) est positionné sur une couverture supérieure (4) du réacteur (2), et comprenant aussi :
- au moins un dispositif (17) fixé sur la couverture supérieure (4) du réacteur (2) apte à mettre en rotation le dispositif cylindrique (16) le long de son axe, pour éliminer d'une surface de ce substrat (19) les résidus de solution fondue ;
- au moins un moyen de support (18) apte à accueillir un substrat (19) acheminé par un moyen de transport (14) ;
- au moins un système thermique contenant une plaque froide (20) et un réchauffeur annulaire à impulsion (23) aptes à chauffer et refroidir à impulsions le substrat (19) en favorisant une procédure de formation de nanostructures épitaxiales ;
- au moins un échangeur de chaleur mobile (21) ;
- au moins un dispositif de mouvement (22) ;
**caractérisé en ce qu'**un dispositif de mouvement (22) au moins est en mesure de déplacer l'échangeur de chaleur (21) le long d'un axe du dispositif cylindrique (16), (a) à partir d'une surface d'une des plaques froides (20) vers une surface supérieure de l'un des substrats (19) et inversement, en canalisant un refroidissement à impulsions sur ce substrat (19), ou bien (b) à partir de la surface supérieure de l'un des substrats (19) vers la surface latérale interne d'un réchauffeur annulaire à impulsion (23) et inversement, en canalisant un chauffage à impulsions sur ce substrat (19).

2. Appareil (100), selon la revendication 1, **caractérisé en ce qu'**il comprend au moins une enveloppe extérieure (1) constituée de :
- au moins une chambre à vide (13) apte à contenir un moyen de contenance (15) et l'un des moyens de transport (14), pendant le développement d'une phase de chargement et d'une phase de déchargement des moyens (14) et (15) ;
- au moins deux dispositifs de mouvement (9) et (10) aptes à déplacer le système thermique (3) ;
- au moins un dispositif de mouvement (6) apte à déplacer le réacteur (2), positionné sur la surface supérieure interne de l'enveloppe extérieure (1) à travers deux éléments de fixation (7) et (8) au moins ;
- au moins un dispositif de fixation (11) apte à relier au moins une couverture supérieure (4) du réacteur (2) à la surface latérale interne de l'enveloppe extérieure (1) et à permettre un déplacement horizontal de la couverture supérieure (4), pour faciliter la communication entre la chambre (13) et le réacteur (2).

3. Appareil (100), selon la revendication 1, **caractérisé en ce que** l'alliage à bas point de fusion est contenu dans un moyen de contenance (15) au moins.

4. Appareil (100), selon la revendication 1, **caractérisé en ce que** le système de manutention comprend au moins un dispositif de positionnement tournant (26) et au moins deux dispositifs de mouvement (27) et (28) en mesure de favoriser le développement de déplacements synchrones du moyen de transport (14) contenant le substrat (19) et d'un moyen de contenance (15) contenant l'alliage à bas point de fusion, à l'intérieur de l'enveloppe extérieure (1).

5. Appareil (100), selon la revendication 1, **caractérisé en ce qu'**un réacteur (2) au moins est positionné verticalement dans l'enveloppe extérieure (1) et comprend aussi :
- au moins l'une des couvertures supérieures (4) fixée sur une surface latérale interne de l'enveloppe extérieure (1) ; la couverture supérieure (4) est dotée au moins d'une entrée de chargement (12) d'un moyen gazeux ;
- au moins une couverture inférieure (5) fixée sur la surface inférieure interne de l'enveloppe extérieure (1) dotée au moins d'une entrée de déchargement (24) d'un moyen gazeux.

6. Appareil (100), selon la revendication 4, **caractérisé en ce que** le dispositif de positionnement tournant (26) présente une surface discoïdale dotée au moins de deux logements aptes à accueillir l'un des moyens de transport (14) et l'un des moyens de contenance (15).

7. Appareil (100), selon la revendication 4 ou 6, **caractérisé en ce que** le dispositif de positionnement (26) est apte à tourner et il est composé au moins d'un mécanisme de rotation (25) et d'un organe de transmission passant par le centre du dispositif (26), fixé sur une surface inférieure interne de l'enveloppe extérieure (1).

8. Appareil (100), selon la revendication 4, **caractérisé en ce que** le premier dispositif de mouvement (27) est doté au moins d'un organe de transmission fixé sur une surface inférieure interne de l'enveloppe extérieure (1), apte à transférer, parallèlement à un axe du réacteur (2), au moins l'un des moyens de transport (14) et au moins l'un des moyens de contenance (15) depuis la chambre (13) vers le dispositif de positionnement (26) et inversement.

9. Appareil (100), selon la revendication 4, **caractérisé en ce que** le second dispositif de mouvement (28) est doté au moins d'un organe de transmission fixé sur la surface inférieure interne de l'enveloppe extérieure (1), apte à déplacer verticalement, le long d'un axe du dispositif cylindrique (16), au moins l'un des moyens de transport (14), en favorisant l'accrochage entre l'un des moyens de support (18) et l'un des substrats (19) acheminé par l'un des moyens de transport (14).

10. Appareil (100), selon la revendication 4, **caractérisé en ce qu'**un second dispositif de mouvement (28) est doté au moins d'un organe de transmission fixé sur une surface inférieure interne de l'enveloppe extérieure (1), apte à déplacer verticalement, le long d'un axe du dispositif cylindrique (16) au moins l'un des moyens de contenance (15) à proximité d'une surface inférieure du substrat (19) relâché précédemment sur les moyens de support (18) par les moyens de transport (14), en favorisant la formation d'une chambre de croissance entre le substrat (19) et l'alliage à bas point de fusion conservé dans les moyens de contenance (15).

11. Procédure de croissance pour la production de nanostructures épitaxiales avec matrices idéales à points quantiques à travers un appareil (100) selon l'une des revendications précédentes, **caractérisé en ce qu'**il comprend les phases suivantes :
a) prédisposition d'un des réacteurs (2) en créant du vide à l'intérieur du réacteur (2) et en produisant un flux d'un moyen gazeux apte à chauffer le système thermique (3) et le réacteur (2) jusqu'à atteindre la température préétablie ;
b) prédisposition dans la chambre (13), pendant une première phase de chargement, de l'un des moyens de transport (14) contenant l'un des substrats (19) et l'un des moyens de contenance (15) contenant au moins un alliage à bas point de fusion ;
c) transfert et positionnement séquentiel des moyens de transport (14) et des moyens de contenance (15) sur le dispositif de positionnement tournant (26) à travers le premier dispositif de mouvement (27) ;
d) positionnement initial des moyens de transport (14) contenant le substrat (19), à travers une rotation du dispositif de positionnement (26) ;
e) positionnement initial des moyens de contenance (15) dans un logement du dispositif de positionnement tournant (26), séquentiel à un logement accueillant les moyens de transport (14) ;
f) libération du substrat (19), acheminé par les moyens de transport (14), à travers l'action du second dispositif de mouvement (28) apte à déplacer verticalement, le long d'un axe du dispositif cylindrique (16), le moyen de transport (14) et accrocher ce dernier et le substrat relatif (19) sur les moyens de support (18) ;
g) déplacement vertical le long d'un axe du dispositif cylindrique (16), à travers le second dispositif de mouvement (28), des moyens de transport (14) sur un logement du dispositif de positionnement tournant (26) ;
h) rotation du dispositif de positionnement (26), à travers le mécanisme de rotation (25) apte à positionner les moyens de transport (14) au niveau du premier dispositif de mouvement (27) ;
i) déplacement vertical parallèlement à un axe du dispositif cylindrique (16), à travers le premier dispositif de mouvement (27), des moyens de transport (14) dans la chambre (13) pour une phase de déchargement des moyens de transport (14) ;
j) rotation du dispositif de positionnement (26), à travers le mécanisme de rotation (25), pour le positionnement des moyens de contenance (15) au niveau du substrat (19) fixé avec les moyens de support (18) au dispositif cylindrique (16) ;
k) déplacement vertical le long d'un axe du dispositif cylindrique (16) des moyens de contenance (15), à travers une action du second dispositif de mouvement (28), en permettant un contact entre l'alliage à bas point de fusion conservé dans les moyens de contenance (15) et le substrat (19) ainsi que la formation entre les moyens de contenance (15) et le substrat (19) d'une chambre de croissance pour cristalliser les matrices de points quantiques à conductibilité de type n ;
1) formation d'une nanocouche épitaxiale qui canalise une impulsion de refroidissement sur le substrat (19) ; l'impulsion de refroidissement est obtenue par un déplacement, le long d'un axe du dispositif cylindrique (16) à travers le dispositif de mouvement (22), de l'échangeur de chaleur (21) initialement au contact de la surface de la plaque froide (20) ayant une température inférieure à celle du substrat (19), et successivement au contact de la surface supérieure du substrat (19) ;
m) dissolution partielle de la nanocouche épitaxiale en canalisant sur le substrat (19) une impulsion de chauffage obtenue par un déplacement, le long d'un axe du dispositif cylindrique (16) à travers le dispositif de mouvement (22), de l'échangeur de chaleur (21) à partir de la surface supérieure du substrat (19) vers la surface latérale interne du réchauffeur annulaire dont la température est supérieure à celle du substrat (19), et inversement ;
n) déplacement vertical le long d'un axe du dispositif cylindrique (16), à travers le second dispositif de mouvement (28), des moyens de contenance (15) sur le logement du dispositif de positionnement tournant (26), avec l'éloignement conséquent de l'alliage à bas point de fusion conservé dans les moyens de contenance (15) par rapport à la surface du substrat (19) ;
o) élimination des résidus de l'alliage à bas point de fusion présents sur la surface du substrat (19) à travers l'activation du dispositif (17) apte à faire tourner le dispositif cylindrique (16) le long de son axe, et collecte des résidus des moyens de contenance (15) situés dans le logement sur le dispositif de positionnement (26);
p) rotation du dispositif de positionnement (26), à travers le mécanisme de rotation (25), apte à positionner simultanément les moyens de contenance (15) au niveau du premier dispositif de mouvement (27) et des seconds moyens de contenance (15) qui contiennent un second alliage à bas point de fusion au niveau du substrat (19), fixé à l'aide des moyens de support (18) au dispositif cylindrique (16) ;
q) répétition des phases de j) à p) pour les seconds moyens de contenance (15) qui contiennent le second alliage à bas point de fusion ;
r) rotation du dispositif de positionnement (26), à travers un mécanisme de rotation (25), apte à positionner simultanément les seconds moyens de contenance (15) au niveau du premier dispositif de mouvement (27) et des troisièmes moyens de contenance (15) qui contiennent un troisième alliage à bas point de fusion, au niveau du substrat (19), fixé à l'aide des moyens de support (18) au dispositif cylindrique (16) ;
s) répétition des phases de k) à o) pour les troisièmes moyens de contenance (15) qui contiennent le troisième alliage à bas point de fusion ;
t) rotation du dispositif de positionnement (26), à travers le mécanisme de rotation (25), apte à positionner simultanément les troisièmes moyens de contenance (15) au niveau du premier dispositif de mouvement (27) et des derniers moyens de contenance (15) qui contiennent le dernier alliage à bas point de fusion, au niveau du substrat (19), fixé à l'aide des moyens de support (18) au dispositif cylindrique (16) ;
u) déplacement vertical le long d'un axe du dispositif cylindrique (16), à travers le premier dispositif de mouvement (27), des troisièmes moyens de contenance (15) dans la chambre (13) pour une phase de déchargement des moyens de contenance (15) ;
v) répétition des phases de k) à o) pour les derniers moyens de contenance (15) qui contiennent l'alliage à bas point de fusion ;
w) répétitions séquentielles des phases de c) à v) pour obtenir une nanostructure épitaxiale multicouche hétérogène avec des matrices idéales à points quantiques dans un seul substrat ;
x) déplacement vertical, le long d'un axe du dispositif cylindrique (16) à travers le second dispositif de mouvement (28), du substrat (19) avec une nanostructure multicouche hétérogène augmentée, sur le logement du dispositif de positionnement tournant (26) ;
y) rotation du dispositif de positionnement (26), à travers le mécanisme de rotation (25), apte à positionner le substrat (19) au niveau du premier dispositif de mouvement (27) ;
z) déplacement vertical le long d'un axe du dispositif cylindrique (16), à travers le premier dispositif de mouvement (27), du substrat (19) dans la chambre (13) pour une phase de déchargement, pour l'extraction finale de la nanostructure épitaxiale multicouche hétérogène produite ; et
aa) déplacement vertical éventuel le long d'un axe du dispositif cylindrique (16), à travers le premier dispositif de mouvement (27), des moyens de contenance (15) dans la chambre (13) pour une phase de rechargement des moyens (15) quand l'alliage à bas point de fusion est épuisé, pendant la procédure de croissance, dans les moyens de contenance (15).
